Europäisches Patentamt

European Patent Office

Office européen des brevets

(19)

(11) Veröffentlichungsnummer: **0 073 327**
**B1**

(12) **EUROPÄISCHE PATENTSCHRIFT**

(45) Veröffentlichungstag der Patentschrift:
25.11.87

(21) Anmeldenummer: 82106343.5

(22) Anmeldetag: 15.07.82

(51) Int. Cl.⁴: **C 23 C 18/16,** C 23 C 20/02,
C 25 D 5/56, H 01 L 31/00,
H 05 K 1/03, C 08 K 5/00,
B 01 J 31/22

(54) **Verfahren zur Abscheidung von Metallen auf elektrisch leitfähigen, polymeren Trägern und Verwendung der erhaltenen Materialien.**

(30) Priorität: 14.08.81 DE 3132218

(43) Veröffentlichungstag der Anmeldung:
09.03.83 Patentblatt 83/10

(45) Bekanntmachung des Hinweises auf die Patenterteilung:
25.11.87 Patentblatt 87/48

(84) Benannte Vertragsstaaten:
BE DE FR GB NL

(56) Entgegenhaltungen:
EP-A-0 036 118
CH-A-568 399
DE-B-2 116 389

JOURNAL OF THE CHEMICAL SOCIETY, Chemical Communication, Band 14, 1979; P.J.NIGREY et al.: "Electro-chemistry of polyacetylene (CH)x: Electrichemical doping of (CH)x films to the metallic state" Seiten 594-595

(73) Patentinhaber: BASF Aktiengesellschaft, Carl-Bosch- Strasse 38, D-6700 Ludwigshafen (DE)

(72) Erfinder: Naarmann, Herbert, Dr., Haardtblick 15, D-6719 Wattenheim (DE)
Erfinder: Muench, Volker, Dr., Luitpoldstrasse 114, D-6700 Ludwigshafen (DE)
Erfinder: Penzien, Klaus, Dr., Bensheimer Ring 18, D-6710 Frankenthal (DE)

EP 0 073 327 B1

**Description**

Die Erfindung betrifft ein Verfahren zur Abscheidung von Metallen auf elektrisch leitfähigen polymeren Trägern.

Bei dem erfindungsgemäßen Verfahren werden dotierte elektrisch leitfähige Polymere, insbesondere Polyacetylene, als Elektrode geschaltet und auf diesen organischen Elektroden Metall feinst verteilt abgeschieden oder die Polymeren als Kristallisationskeime eingesetzt, oder in Flüssigkeitsphase Metall direkt durch Zersetzung oder Entladung abgeschieden.

Es ist bereits bekannt, daß Polymere wie Poly(acetylen) (vgl. A. McDiarmid und A.G. Heeger, "Synthetic Metals", Band 1, Seite 101 bis 118 (1980)) oder Poly(p-phenylen) (vgl. R.H. Baughman et al., "Journal of Chemical Physics", Band 73, Heft 8, Seiten 4098 bis 4102 (1980)) mit Metallen wie Li, Na, K, Rb, Cs zu elektrisch leitfähigen Polymeren umgesetzt werden können. Als Werkstoffe besitzen sie wegen ihres geringen Gewichtes Vorteile gegenüber reinen Metallen; sie haben jedoch den Nachteil sehr sauerstoffempfindlich zu sein (vgl. J.M. Pochan et al., "Journal of Polymer Science, Polymer Letters Edition", Band 18, Seiten 447 bis 451 (1980)). Die Morphologien solcher potentiell leitfähiger Polymere, insbesondere die Fibrillenmorphologie von Poly(acetylen) (vgl. F.E. Karasz et al., Nature, Band 282, Nummer 5736, Seiten 286 bis 288 (1979)) lassen sie als geeignete Trägermaterialien für Metalle erscheinen.

Es ist weiterhin bekannt, daß Metalle mit negativen Normalpotentialen $E_0$ (V) wie z. B. Li($E$ = -3,045 V), Na($E_0$ = -2,71 V), K($E_0$ = -2,924 V), Rb($E$ = -2,925 V) oder Cs($E_0$ = -2,923 V) (vgl. "Handbook of Chemistry and Physics", Edition, 1975 bis 1976, CRC press, D 141 bis D 148) Metallkationen mit weniger negativen Normalpotentialen zu den Metallen reduzieren können. Die Anordnung der Metalle nach steigendem Normalpotential nennt man die elektrochemische Spannungsreihe, so wie sie z. B. in K.-H. Naser, "Physikalische Chemie", VEB-Verlag, Leipzig, 1971, Seiten 329 bis 355 definiert ist. Zum Begriff des Normalpotentials $E_0$ siehe auch dort.

Es ist weiterhin bekannt, daß eine Reduktion eines Metallkations zu einem Metall auch elektrochemisch erzwungen werden kann, wenn man in einer Elektrolytzelle, wie sie z.B. in R. Brdicka "Grundlagen der Physikalischen Chemie", VEB Verlag, Leipzig (1968), Seiten 668 bis 671, beschrieben ist, eine Metallelektrode in eine Lösung des Metallkations desselben Elements (oder eines anderen) eintaucht und die Metallelektrode als Kathode schaltet. Nach dem Erreichen der dem Normalpotential oder der Abscheidungsspannung (vgl. K. Schäfer, "Physikalische Chemie", 2. Auflage, Springer Verlag, Berlin, Seite 249) entsprechenden Spannung beginnt die Reduktion des Metallkations und die Abscheidung des Metalls auf der Kathode, so wie es z. B. bei der technischen Kupferelektrolyse beschrieben ist (vgl. Hollemann/Wiberg, "Lehrbuch der anorganischen Chemie", 71. bis 80. Auflage, de Gruyter (1971), Seiten 708 bis 711).

Es ist ferner bekannt, daß Metalle durch Aufschmelzen (vgl. G. Brauer, "Handbuch der Präparativen Anorganischen Chemie", Band 2, F. Enke Verlag, Stuttgart, Seiten 946 bis 947) oder durch Reduktion [Hollemann/Wiberg, "Lehrbuch der anorganischen Chemie", 71. bis 80. Auflage, Seiten 723 bis 724 oder N.V. Roman und N.V. Demidenko in "Russian Chemical Reviews", Band 44, Seiten 2150 bis 2170 (1975)] oder durch Imprägnierung inerter Festkörper, wie $Al_2O_3$, $SiO_2$, Aktivkohle, $TiO_2$, Zeolithe, MgO, Siliciumcarbid durch Metallsalzlösungen und anschließender Reduktion, wie es z. B. von R. Krabetz und W.D. Mross in "Ullmanns Encyklopädie der technischen Chemie", 4. Auflage, Band 13, Verlag Chemie, Weinheim (1977), Seiten 517 bis 569 beschrieben ist, aufgebracht werden können. Solchermaßen feinverteilte Metalle besitzen hohe katalytische Aktivitäten, sie besitzen jedoch den Nachteil, daß das Trägermaterial nicht elektrisch leitfähig und oft schwer ist.

Es ist ferner bekannt, daß Metalle auf Trägermaterialien durch thermische Zersetzung von Metallcarbonylen wie $Fe_2(CO)_9$ (vgl. D. Nicholls in "Comprehensive Inorganic Chemistry), Band 3, Seiten 995 bis 996, Pergamon Press, Oxford, 1973) aufgebracht werden können.

Es ist auch bereits bekannt, daß feinstverteilte Metalle wie z. B. Raney-Nickel (vgl. "Organikum", 1. Auflage, VEB-Verlag, Leipzig (1970), Seiten 814 bis 720) hohe katalytische Wirkung besitzen, sie sind jedoch nicht in irgend einer Form als Werkstoff verwendbar.

In der älteren, nicht vorveröffentlichten EP-A- 36 118 wird vorgeschlagen, konjugierte Polymere z. B. Polyacetylen mit Metallkationenverbindungen elektrochemisch zu dopen, wobei solche Verbindungen von Metallen verwendet wurden, deren elektronegatives Potential nach Pauling nicht größer als 1,6 ist. Solche Metalle sind z. B. die Alkali und Erdalkalimetalle und bestimmte Metalle der Gruppe 3 (Y, Sc und Al) oder der Gruppe 4 (Zr und Ti) des periodischen Systems der Elemente.

Es bestand die Aufgabe, Systeme zu schaffen, bei denen Metalle feinstverteilt auf leichten, elektrisch leitfähigen, polymeren Trägern aufgebracht sind, wobei die elektrische Leitfähigkeit des Systems nicht sinken sollte, die Luftstabilität erhöht sein sollte, die katalytische Aktivität nicht erniedrigt sein sollte und im Vergleich zu üblichen Metall/Träger-Systemen hohe Gewichtsersparnisse erzielt werden sollten. Desweiteren sollten solche Systeme die vorteilhaften Eigenschaften polymerer, organischer Systeme wie Flexibilität, Verformbarkeit, Dehnbarkeit, leichte Verarbeitbarkeit usw. aufweisen.

Diese Aufgabe wurde dadurch gelöst, daß man aus einer Lösung einer Metallkationenverbindung der allgemeinen Formel (I)

$$ML_m^1 \ L_n^2 \ L_o^3 \ L_p^4$$

worin M $Au^\oplus$, $Au^{3\oplus}$, $Pt^{2\oplus}$, $Hg^{2\oplus}$, $Os^{4\oplus}$, $Pd^{2\oplus}$, $Ag^\oplus$,

$Hg^{2\oplus}$, $Ir^{3\oplus}$, $Te^{4\oplus}$, $Se^{4\oplus}$, $Cu^\oplus$, $Cu^{2\oplus}$, $Rh^{3\oplus}$, $Re^{3\oplus}$, $As^{3\oplus}$,

$Sb^{3\oplus}$, $Bi^{3\oplus}$, $Sn^{4\oplus}$, $Mo^{6\oplus}$, $W^{6\oplus}$, $Fe^{3\oplus}$, $Sn^{2\oplus}$, $Pb^{2\oplus}$, $Ge^{4\oplus}$,

$Ni^{2\oplus}$, $Co^{2\oplus}$, $Tl^\oplus$, $Cd^{2\oplus}$, $Fe^{2\oplus}$, $Cr^{2\oplus}$, $Ga^{3\oplus}$, $Cr^{3\oplus}$, $Ta^{5\oplus}$,

$Zn^{2\oplus}$, $In^{3\oplus}$, $Y^{3\oplus}$, $Ru^{5\oplus}$, $Mn^{2\oplus}$, $Si^{4\oplus}$, $V^{2\oplus}$, $Zr^{4\oplus}$, $Hf^{4\oplus}$,

$Ce^{3\oplus}$, $Al^{3\oplus}$, $Be^{2\oplus}$, $Ti^{2\oplus}$, $U^{3\oplus}$, $Th^{4\oplus}$ oder $Np^{3\oplus}$, und

$L^1$, $L^2$, $L^3$, $L^4$ gleich oder verschieden sind, m, n, o und p die Zahlen 0 bis 6 sind, m, n, o und p zusammen genommen die Zahlen 1 bis 8 sind, wobei $L^1$, $L^2$, $L^3$, $L^4$

$F^\ominus$, $Cl^\ominus$, $Br^\ominus$, $I^\ominus$, $CN^\ominus$, CO, $NO_3^\ominus$, $CH_3COO^\ominus$, $CH_3SO_3^\ominus$ oder

$H_3PO_2^\ominus$ oder als Ligand RCN (mit R = $C_1$-$C_6$-Alkyl, Cycloalkyl, Aryl),

$NR^1R^2R^3$ (mit $R^1$, $R^2$, $R^3$ gleich oder verschieden und $R^1 = R^2 = R^3 = H$, $C_1$-$C_{10}$-Alkyl, Cycloalkyl, Aryl) $R^1R^2N$-$(CH_2)_n$-$NR^1R^2$ [mit $R^1$, $R^2$ gleich oder verschieden mit $R^1 = R^2 = C_1$-$C_6$-Alkyl, Cycloalkyl; n = 1 bis 6],

$PR^1R^2R^3$ [mit $R^1$, $R^2$, $R^3$ gleich oder verschieden mit $R^1 = R^2 = R^3 = H$,

$C_1$-$C_6$-Alkyl, Cycloalkyl, Aryl, $C_1$-$C_6$-Alkoxi, Cycloalkoxi, Aryloxi],

$OPR^1R^2R^3$ [mit $R^1$, $R^2$, $R^3$ gleich oder verschieden mit $R^1 = R^2 = R^3 = C_1$-$C_6$-Alkyl, Cycloalkyl, Aryl, $C_1$-$C_6$-Alkoxi, Cycloalkoxi, Aryloxi], Pyridin, Dimethylsulfoxid, Acetylaceton, Ether, Hexamethylphosphorsäuretriamid, N-Methylpyrrolidon, Sulfolan, Propandiol-1,2-carbonat, Aceton, Ethylacetat, Dimethylformamid oder N,N-Dimethylacetamid sind oder aus einer Suspension von $Fe(CO)_9$ in einem aprotisch polaren oder unpolaren Lösungsmittel, das Metall auf einem polymeren, elektrisch leitfähigen Träger der allgemeinen Formel (II):

$[M''_y (P)]_x$ (II),

worin M″ = Li, Na, K, Rb, Cs;
P = -(CH)-, -($C_6H_4$)-, -($C_4H_2S$)-, -($C_6H_4S$)-, -($C_4H_2O$)-, -($C_4H_2NH$)-, -($C_6H_4O$)-, -($C_5H_3N$)-
Y = 0,001 bis 0,6 und x = 5 bis 1000,
oder auf einem polymeren, elektrisch leitfähigen Träger der allgemeinen Formel (III):

$[(P) (X)_y]_x$ (III),

worin P den bei Formel (II) aufgeführten Gruppen entspricht,
X = $ClO_4^\ominus$, $AsF_6^\ominus$, $PF_6^\ominus$, $SbF_6^\ominus$, $BF_4^\ominus$, $HSO_4^\ominus$, $CF_3SO_3^\ominus$, $Br^\ominus$,
X = 0,001 bis 0,6 und x = 5 bis 1000,
durch Reduktion in feinverteiltem Zustand abscheidet.

Nach bevorzugter Verfahrensweise wird die Abscheidung des Metalls auf einem elektrisch leitfähigen, polymeren Träger der allgemeinen Formel (II) chemisch durchführt, wenn y = 0,1 bis 0,6 und x = 5 bis 1000, gegebenenfalls in Gegenwart eines Hilfsreduktionsmittels wie Hydrazin, $SnCl_2$ oder $H_3PO_2$.

Bevorzugt ist auch ein Verfahren, bei dem man die Abscheidung des Metalles auf einem elektrisch leitfähigen, polymeren Träger der allgemeinen Formel (II) oder (III) elektrochemisch durchführt, wenn y = 0,001 bis 0,1 und x = 5 bis 1000, wobei der elektrisch leitfähige, polymere Träger in einer Elektrolytzelle als Kathode geschaltet ist bzw. auf einer Kathode aufgebracht ist.

Als aprotisch polare Lösungsmittel werden bevorzugt verwendet: Acetonitril, Sulfolan, Propandiol-1,2-carbonat, Aceton, Acetylaceton, Ethylacetat, Diethylether, Trimethylphosphat, Tributylphosphat, Dimethylformamid, N,N-Dimethylacetamid, N-Methylpyrrolidon, Dimethylsulfoxid oder Hexamethylphosphorsäuretriamid, ist und das aprotisch unpolare Lösungsmittel n-Hexan, n-Heptan, n-Octan, Petrolether, Ligroin, Benzol, Toluol oder Xylol ist.

Geeignet ist auch ein Verfahren, bei dem die Abscheidung des Metalles auf dem elektrisch leitfähigen, polymeren Träger der allgemeinen Formel (II) bei Temperaturen von -100 bis +100° C durchgeführt wird.

## Beispiele 1 bis 10

Es wurde ein gemäß EP-A2-36 118, Beispiel 2 hergestellter dotierter Polyacetylen-Film - p-(CH)$_x$- als Kathode geschaltet und bei Variation des Elektrolyten bzw. der gelösten Metallsalze, die Kationen an der Kathode abgeschieden.

Der Polyacetylenfilm war mit $ClO_4^\ominus$ gedopt und diente als Kathode. Als Gegenelektrode diente eine Pt-Anode. Als Elektrolyt wurde Propylencarbonat eingesetzt, das 0,1 M Metallsalze enthielt. Die Spannung betrug 3 Volt, die Stromstärke 500 m Amp.

In der folgenden Übersicht sind die Variationen der Metalle sowie die abgeschiedenen Mengen (in

3

Gewichtsprozent, bezogen auf die p-(CH)$_x$-Elektrode) der einzelnen Metalle an der Kathode wiedergegeben.
Für jeden Versuch wurde jeweils eine neue p-(CH)$_x$-Elektrode wie auch ein neuer Elektrolyt verwendet.
Die Reaktionszeit betrug wenn nicht anders angegeben, jeweils eine Stunde.

**Tabelle 1**

| Beispiel Nr. | Metallsalz | | abgeschiedene Menge in Gew.% |
|---|---|---|---|
| 1 | Pb(NO$_3$)$_2$ | | 160 |
| 2 | Cu(NO$_3$)$_2$ | | 154 |
| 3 | Bi(NO$_3$)$_3$ | | 202 |
| 4 | AgNO$_3$ | | 180 |
| 5 | TlNO$_3$ | | 175 |
| 6 | Pb(NO$_3$)$_2$ | 2 h | 290 |
| 7 | Pb(NO$_3$)$_2$ | 3 h | 320 |
| 8 | Pb(NO$_3$)$_2$ | 4 h | 450 |
| 9 | Zn(NO$_3$)$_2$ | | 150 |
| 10 | Mn(NO$_3$)$_2$ | | 180 |

**Beispiel 11 bis 19**

Ein entsprechend "Synthetic Metals", Band 1, Seiten 101 bis 118 (1980) hergestellter dotierter Poly(acetylen)-Film wurde als Kathode geschaltet und bei Variation des Elektrolyten bzw. der gelösten Metallsalze die Kationen an der Kathode abgeschieden.

Das (CH)$_x$ war mit Lithium dotiert und diente als Kathode. Als Gegenelektrode diente eine Platinanode. Als Elektrolyt wurde Propylencarbonat eingesetzt, das 0,1 M Metallsalze enthielt. Die Spannung betrug 3 Volt, die Stromstärke 500 mAmp.

In der folgenden Übersicht sind die Variationen der Metalle sowie der abgeschiedenen Mengen (in Gewichtsprozent, bezogen auf die n-(CH)$_x$-Elektrode) der einzelnen Metalle an der Kathode wiedergegeben.
Für jeden Versuch wurde jeweils eine neue n-(CH)$_x$-Elektrode, wie auch ein neuer Elektrolyt verwendet.
Die Reaktionszeit betrug, wenn nicht anders angegeben, jeweils eine Stunden.

**Tabell 2**

| Beispiel Nr. | Metallsalz | | abgeschiedene Menge in Gew.% |
|---|---|---|---|
| 11 | FeBr$_3$ wasserfrei | 2 h | 120 |
| 12 | [Ni(NH$_3$)$_6$]$^{2\oplus}$(Br$^\ominus$)$_2$ | | 147 |
| 13 | [Cu(Pyridin)$_4$]$^\oplus$Cl$^\ominus$ | | 206 |
| 14 | Mn$^{2\oplus}$(CH$_3$COO$^\ominus$)$_2$ wasserfrei | | 200 |
| 15 | [Mn(CO)$_4$(NH$_3$)$_2$]$^\oplus$Br$^\ominus$ | | 195 |
| 16 | [Co(HMPT)$_4$]$^{2\oplus}$(ClO$_4$)$^\ominus)^2$ | 3 h | 410 |
| 17 | [Ni(HMPT)$_4$]$^{2\oplus}$(ClO$_4^\ominus$)$_2$ | | 390 |
| 18 | Zn$^{2\oplus}$(H$_3$PO$_2^\ominus$)$_2$ | | 150 |
| 19 | Pb$^{2\oplus}$(CH$_3$COO$^\ominus$)$_2$ wasserfrei | 3 h | 423 |

HMPT: Hexamethylenphosphorsäuretriamid

**Beispiel 20 bis 29**

Ein nach "Synthetic Metals", Band 1, Seiten 101 bis 118 (1980) hergestellter hoch n-dotierter Poly(acetylen)-Film wurde in eine Lösung einer Metallverbindung getaucht. Bei Variation der Metallverbindungen und der Lösungsmittel wurden die Metalle auf dem (CH)$_x$-Film abgeschieden.

Der (CH)$_x$-Film war mit Natrium hoch dotiert.

In der folgenden Übersicht sind die Variationen der Metalle und Lösungsmittel sowie die abgeschiedenen Mengen (in Gewichtsprozent, bezogen auf den n-(CH)$_x$-Film) der einzelnen Metalle angegeben.
Für jeden Versuch wurde jeweils ein neuer n-(CH)$_x$-Film, wie auch eine neue Metallverbindungslösung verwendet.
Die Reaktionszeit betrug, wenn nicht anders angegeben, jeweils eine Stunde, die Reaktionstemperatur 25°C.

**Tabelle 3**

| Beispiel Nr. | Metallverbindung | Lösungsmittel | | abgeschiedene Menge in Gew.% |
|---|---|---|---|---|
| 20 | $[Pt(CH_3CN)_2{}^{2\oplus}(Cl^\ominus)_2]$ | $CH_3CN$ | | 410 |
| 21 | $[Pd(C_6H_5CN)]_2{}^{2\oplus}(Cl^\ominus)_2$ | $CH_3CN$ | | 370 |
| 22 | $[Cu(HMPT)_4]^\oplus Br^\ominus$ | HMPT | 3 h | 402 |
| 23 | $[Ag(NH_3)_2]^\oplus Cl^\ominus$ | DMSO | | 315 |
| 24 | $HgCN_2$ | $CH_3CN$ | | 450 |
| 25 | $[Cu(Pyridin)_4]^{2\oplus}(Br^\ominus)_2$ | | | |
| 26 | $[Au(CH_3(CN)_2]^\oplus Br^\ominus$ | $CH_3CN$ | | 520 |
| 27 | $[Pd(TBP)_4]^{2\oplus}(Cl_2{}^\ominus)_2$ | TBP[a] | | 320 |
| 28 | $Pt[N(CH_3)_3]_2Cl_2$ | DMF | | 415 |
| 29 | $Pd[N(CH_3)_3]_2Cl_2$ | NMP | | 325 |

TBP = Tributylphosphat

**Beispiel 30 bis 31**

Ein nach "journal of Chemical Physics", Band 73, Heft 8, Seiten 4098 bis 4102 (1980) hergestelltes pulverförmiges, hoch-n-dotiertes Poly(p-phenylen) wurde mit einer Metallverbindung, gelöst in einem Lösungsmittel, in Kontakt gebracht. Unter Variation der Metallverbindung und der Lösungsmittel wurden die Metalle auf dem Poly(p-phenylen) abgeschieden.

Das Poly(p-phenylen) war mit Natrium dotiert. Für jeden Versuch wurde jeweils eine neue Charge an Poly(p-phenylen)-Natrium, wie auch eine neue Metallverbindungslösung verwendet.

**Tabelle 4**

| Beispiel Nr. | Metallverbindung | Lösungsmittel | | abgeschiedene Menge in Gew.% |
|---|---|---|---|---|
| 30 | $Pd(CH_3CN)_2Cl_2$ | NMP | 4 h | 280 |
| 31 | $Pt(CH_3CN)_2Cl_2$ | DMF | | 310 |

**Beispiel 32 bis 34**

Es wurde wie bei den Beispielen 21 bis 30 beschrieben gearbeitet und zusätzlich jedoch noch ein Hilfsreduktionsmittel zugesetzt. Unter Variationen der Metallverbindungen und der Lösungsmittel wurden die Metalle auf den $(CH)_x$-Filmen abgeschieden.

**Tabelle 5**

| Beispiel Nr. | Metallverbindung | Lösungsmittel | Hilfsreduktionsmittel | abgeschiedene Metallmenge in Gew.% |
|---|---|---|---|---|
| 32 | $[Ag(NHC_4H_9)_2]Cl$ | NMP | $N_2H_4$ | 350 |
| 33 | $NiCl_2$ wasserfrei | DMSO | $H_3PO_2$ wasserfrei | 310 |
| 34 | $Pd(CH_3CN)_2Cl_2$ | Propylendicarbonat | $SnCl_2$ wasserfrei | 470 |

Reaktionsdauer: 1 h, T = 25°C.

**Beispiel 35**

Ein n-dotierter $(CH)_x$-Film der Zusammensetzung $Na_{0,023}(CH)_x$ wird mit einer Suspension von $Fe(CO)_9$ in Toluol bei 100°C behandelt. Der mit Eisen beschichtete Film wird mit Toluol extrahiert und im Hochvakuum getrocknet. Gewichtszuwachs Eisen: 186 Gew.%, bezogen auf $[Na_{0,023}(CH)]_x$.

**Patentansprüche**

1. Verfahren zur Abscheidung von Metallen auf elektrisch leitfähigen polymeren Trägern, wobei man aus einer Lösung einer Metallkationenverbindung der allgemeinen Formel (I)

$$ML^1_m \cdot L^2_n \ L^3_o \ L^4_p$$

worin M $Au^\oplus$, $Au^{3\oplus}$, $Pt^{2\oplus}$, $Hg^{2\oplus}$, $Os^{4\oplus}$, $Pd^{2\oplus}$, $Ag^\oplus$,
$Hg^{2\oplus}$, $Ir^{3\oplus}$, $Te^{4\oplus}$, $Se^{4\oplus}$, $Cu^\oplus$, $Cu^{2\oplus}$, $Rh^{3\oplus}$, $Re^{3\oplus}$, $As^{3\oplus}$,
$Sb^{3\oplus}$, $Bi^{3\oplus}$, $Sn^{4\oplus}$ $Mo^{6\oplus}$, $W^{6\oplus}$, $Fe^{3\oplus}$, $Sn^{2\oplus}$, $Pb^{2\oplus}$, $Ge^{4\oplus}$,
$Ni^{2\oplus}$ $Co^{2\oplus}$, $Tl^\oplus$, $Cd^{2\oplus}$, $Fe^{2\oplus}$, $Cr^{2\oplus}$, $Ga^{3\oplus}$, $Cr^{3\oplus}$, $Ta^{5\oplus}$,
$Zn^{2\oplus}$, $In^{3\oplus}$, $Y^{3\oplus}$, $Ru^{5\oplus}$, $Mn^{2\oplus}$, $Si^{4\oplus}$, $V^{2\oplus}$, $Zr^{4\oplus}$, $Hf^{4\oplus}$,
$Ce^{3\oplus}$, $Al^{3\oplus}$, $Be^{2\oplus}$, $Ti^{2\oplus}$, $U^{3\oplus}$, $Th^{4\oplus}$, oder $Np^{3\oplus}$, und
$L^1$, $L^2$, $L^3$, $L^4$ gleich oder verschieden sind, m, n, o und p die Zahlen 0 bis 6 sind, m, n, o und p zusammen genommen die Zahlen 1 bis 8 sind, wobei $L^1$, $L^2$, $L^3$, $L^4$
$F^\ominus$, $Cl^\ominus$, $Br^\ominus$, $I^\ominus$, $CN^\ominus$, CO, $NO_3^\ominus$, $CH_3COO^\ominus$, $CH_3SO_3^\ominus$ oder
$H_3PO_2^\ominus$ oder als Ligand RCN (mit R = $C_1$-$C_6$-Alkyl, Cycloalkyl, Aryl),
$NR^1R^2R^3$ (mit $R^1$, $R^2$, $R^3$ gleich oder verschieden und $R^1=R^2=R^3=$H, $C_1$-$C_{10}$-Alkyl, Cycloalkyl, Aryl) $R^1R^2N$-
$(CH_2)_n$-$NR^1R^2$ [mit $R^1$, $R^2$ gleich oder verschieden mit $R^1=R^2=C_1$-$C_6$-Alkyl, Cycloalkyl; n = 1 bis 6],
$PR^1R^2R^3$ [mit $R^1$, $R^2$, $R^3$ gleich oder verschieden mit $R^1=R^2=R^3=$H,
$C_1$-$C_6$-Alkyl, Cycloalkyl, Aryl, $C_1$-$C_6$-Alkoxi, Aryloxi],
$OPR^1R^2R^3$ [mit $R^1$, $R^2$, $R^3$ gleich oder verschieden mit $R^1=R^2=R^3=C_1$-$C_6$-Alkyl, Cycloalkyl, Aryl, $C_1$-$C_6$-Alkoxi, Cycloalkoxi, Aryloxi], Pyridin, Dimethylsulfoxid, Acetylaceton, Ether, Hexamethylphosphorsäuretriamid, N-Methylpyrrolidon,
Sulfolan Propandiol-1,2-carbonat, Aceton, Ethylacetat, Dimethylformamid oder N,N-Dimethylacetamid sind oder aus einer Suspension von $Fe(CO)_9$ in einem aprotisen polaren oder unpolaren Lösungsmittel, das Metall auf einem polymeren, elektrisch leitfähigen Träger der allgemeinen Formel (II):

$[M''_y(P)]_x$ (II)

worin M'' = Li, Na, K, Rb, Cs;
P = -(CH)-, -$(C_6H_4)$-, -$(C_4H_2S)$-, -$(C_6H_4S)$-, -$(C_4H_2O)$-, -$(C_4H_2NH)$-, -$(C_6H_4O)$-, -$(C_5H_3N)$-
y = 0,001 bis 0,6 und x = 5 bis 1000,
oder auf einem polymeren, elektrisch leitfähigen Träger der allgemeinen Formel (III):

$[(P)(X)_y]_x$ (III)

worin P den bei Formel (II) aufgeführten Gruppen entspricht,
X = $ClO_4^\ominus$, $AsF_6^\ominus$, $PF_6^\ominus$, $SbF_6^\ominus$, $BF_4^\ominus$, $HSO_4^\ominus$, $CF_3SO_3$, $Br^\ominus$,
y = 0,001 bis 0,6 und x = 5 bis 1000,
durch Reduktion in feinverteiltem Zustand abscheidet.
2. Verfahren nach Anspruch 1, dadurch gekennzeichnet, daß man die Abscheidung des Metalls auf einen elektrisch leitfähigen, polymeren Träger der allgemeinen Formel (II) chemisch durchführt, wenn y = 0,1 bis 0,6 und x = 5 bis 1000, ist, gegebenenfalls in Gegenwart eines Hilfsreduktionsmittels wie Hydrazin, $SnCl_2$ oder $H_3PO_2$.
3. Verfahren nach Anspruch 1, dadurch gekennzeichnet, daß man die Abscheidung des Metalles auf einem elektrisch leitfähigen, polymeren Träger der allgemeinen Formel (II) oder (III) elektrochemisch durchführt, wenn y = 0,001 bis 0,1 und x = 5 bis 1000, wobei der elektrisch leitfähige, polymere Träger in einer Elektrolytzelle das kathoden-aktive Material darstellt.
4. Verfahren nach Anspruch 1, dadurch gekennzeichnet, daß das aprotisch polare Lösungsmittel Acetonitril, Sulfolan, Propandiol-1,2-carbonat, Aceton, Acetylaceton, Ethylacetat, Diethylether, Trimethylphosphat, Tributylphosphat, Dimethylformamid, N,N-Dimethylacetamid, N-Methylpyrrolidon, Dimethylsulfoxid oder Hexamethylphosphorsäuretriamid, ist und das aprotisch unpolare Lösungsmittel n-Hexan, n-Heptan, n-Octan, Petrolether, Ligroin, Benzol, Toluol oder Xylol ist.
5. Verfahren nach Anspruch 1, dadurch gekennzeichnet, daß die Abscheidung des Metalls auf den elektrisch leitfähigen, polymeren Träger der allgeneinen Formel (II) bei Temperaturen von -100 bis +100°C durchgeführt wird.

6. Verwendung der nach Anspruch 1 hergestellten elektrisch leitfähigen, metallüberzogenen polymeren Träger in der Elektrotechnik zur Herstellung von Sonnenzellen, zur Umwandlung und Fixierung von Strahlung und zur Herstellung elektrischer und magnetischer Schalter und elektrischer Speicher.

7. Verwendung der nach Anspruch 1 hergestellten elektrisch leitfähigen, metallüberzogenen polymeren Träger zur antistatischen Ausrüstung von Kunststoffen.

8. Verwendung der nach Anspruch 1 hergestellten elektrisch leitfähigen, metallüberzogenen polymeren Träger als heterogene Katalysatoren.

**Claims**

1. A process for the deposition of a metal onto an electrically conductive polymeric carrier, wherein a finely divided metal is deposited, from a solution of a metal cation compound of the general formula (I)

$$ML_m^1L_n^2L_o^3L_p^4 \qquad (I),$$

where M is $Au^\oplus$, $Au^{3\oplus}$, $Au^{3\oplus}$, $Pt^{2\oplus}$, $Hg^{2\oplus}$, $Os^{4\oplus}$, $Pd^{2\oplus}$, $Ag^\oplus$, $Hg_2^{2\oplus}$,
$Ir^{3\oplus}$, $Te^{4\oplus}$, $Se^{4\oplus}$, $Cu^\oplus$, $Cu^{2\oplus}$, $Rh^{3\oplus}$, $Re^{3\oplus}$, $As^{3\oplus}$, $Sb^{3\oplus}$, $Bi^{3\oplus}$, $Sn^{4\oplus}$,
$Mo^{6\oplus}$, $W^{6\oplus}$, $Fe^{3\oplus}$, $Sn^{2\oplus}$, $Pb^{2\oplus}$, $Ge^{4\oplus}$, $Ni^{2\oplus}$, $Co^{2\oplus}$, $Tl^\oplus$, $Cd^{2\oplus}$, $Fe^{2\oplus}$, $Cr^{2\oplus}$,
$Ga^{3\oplus}$, $Cr^{3\oplus}$, $Ta^{5\oplus}$, $Zn^{2\oplus}$, $In^{3\oplus}$, $Y^{3\oplus}$, $Ru^{5\oplus}$, $Mn^{2\oplus}$, $Si^{4\oplus}$, $V^{2\oplus}$, $Zr^{4\oplus}$, $Hf^{4\oplus}$,
$Ce^{3\oplus}$, $Al^{3\oplus}$, $Be^{2\oplus}$, $Ti^{2\oplus}$, $U^{3\oplus}$, $Th^{4\oplus}$ or $Np^{3\oplus}$,
$L^1$, $L^2$, $L^3$ and $L^4$ are identical or different, m, n, o and p are each from 1 to 6, and m, n, o and p together are from 1 to 8, $L^1$, $L^2$, $L^3$ and $L^4$ each being $F^\ominus$, $Cl^\ominus$, $Br^\ominus$, $I^\ominus$, $CN^\ominus$, CO, $NO_3^\ominus$, $CH_3COO^\ominus$, $CH_3SO_3^\ominus$ or $H_3PO_2$ or, as a ligand, RCN (where R is $C_1$-$C_6$-alkyl, cycloalkyl or aryl),
$NR^1R^2R^3$ (where $R^1$, $R^2$ and $R^3$ are identical or different and each is H, $C_1$-$C_{10}$-alkyl, cycloalkyl or aryl),
$R_1R_2N$-$(CH_2)_n$-$NR^1R^2$ (where $R^1$ and $R^2$ are identical or different and each is $C_1$-$C_6$-alkyl or cycloalkyl, and n is from 1 to 6),
$PR^1R^2R^3$ (where $R^1$, $R^2$ and $R^3$ are identical or different and each is H, $C_1$-$C_6$-alkyl, cycloalkyl, aryl, $C_1$-$C_6$-alkoxy, cycloalkoxy or aryloxy),
$OPR^1R^2R^3$ (where $R^1$, $R^2$ and $R^3$ are identical or different and each is $C_1$-$C_6$-alkyl, cycloalkyl, aryl, $C_1$-$C_6$-alkoxy, cycloalkoxy or aryloxy), pyridine, dimethylsulfoxide, acetylacetone, ether, hexamethylphosphoric triamide, N-methylpryrrolidone, sulfolane, propanediol, 1,2-carbonate, acetone, ethyl acetate, dimethylformamide or N,N-dimethylacetamide, or from a suspension of $Fe(CO)_9$, in an aprotic polar or non-polar solvent, onto a polymeric, electrically conductive carrier of the general formula (II)

$$[M''_y(P)]_x \ (II),$$

where
M'' is Li, Na, K, Rb or Cs,
P is -(CH)-, -$(C_6H_4)$-, -$(C_4H_2S)$-, -$(C_6H_4S)$-, -$(C_4H_2O)$-, -$(C_4H_2NH)$-, -$(C_6H_4O)$- or -$(C_5H_3N)$-,
y is from 0.001 to 0.6 and x is from 5 to 1,000, or onto a polymeric, electrically conductive carrier of the general formula (III)

$$[(P)(X)_y]_x \ (III),$$

where P is one of the groups listed for formula (II),
X is $ClO_4^\ominus$, $AsF_6^\ominus$, $PF_6^\ominus$, $SbF_6^\ominus$, $BF_4^\ominus$, $HSO_4^\ominus$, $CF_3SO_3^\ominus$ or $Br^\ominus$,
y is from 0.001 to 0.6 and x is from 5 to 1,000,
by reduction.

2. A process as claimed in claim 1, wherein the deposition of the metal onto an electrically conductive, polymeric carrier of the general formula (II), where y is from 0.1 to 0.6 and x is from 5 to 1,000, is carried out chemically in the presence or absence of an auxiliary reducing agent such as hydrazine, $SnCl_2$ or $H_3PO_2$.

3. A process as claimed in claim 1, wherein the deposition of the metal onto an electrically conductive, polymeric carrier of the general formula (II) or (III), where y is from 0.001 to 0.1 and x is from 5 to 1, 000, is carried out electrochemically, the electrically conductive, polymeric carrier being made the cathode in an electrolytic cell.

4. A process as claimed in claim 1, wherein the aprotic polar solvent is acetonitrile, sulfolane, propanediol 1,2-carbonate, acetone, acetylacetone, ethyl acetate, diethyl ether, trimethyl phosphate, tributyl phosphate, dimethylformamide, N,N-dimethylacetamide, N-methylpyrrolidone, dimethylsulfoxide or hexamethylphosphoric triamide, and the aprotic non-polar solvent is n-hexane, n-heptane, n-octane, petroleum ether, ligroin, benzene, toluene or xylene.

5. A process as claimed in claim 1, wherein the deposition of the metal onto the electrically conductive, polymeric carrier of the general formula (II) is carried out at from -100 to +100°C.

6. Use of the electrically conductive, metal-coated polymeric carrier prepared in accordance with claim 1 in electrical engineering for the manufacture of solar cells, for the conversion and fixation of radiation, and for the manufacture of electrical and magnetic switches and electrical storage means.

7. Use of the electrically conductive, metal-coated polymeric carrier prepared in accordance with claim 1 for rendering plastics antistatic.

8. Use of the electrically conductive, metal-coated polymeric carrier prepared in accordance with claim 1 as heterogeneous catalysts.

**Revendications**

1. Procédé pour le dépôt de métaux sur des supports polymères électriquement conducteurs, caractérisé en ce que l'on dépose par réduction, à l'état finement divisé, à partir d'une solution d'un composé contenant des cations métalliques de la formule générale (I)

$$ML_m^1 \ L_n^2 \ L_o^3 \ L_p^4 \qquad (I)$$

dans laquelle M est $Au^{\oplus}$, $Au^{3\oplus}$ $Pt^{2\oplus}$, $Hg^{2\oplus}$, $Os^{4\oplus}$, $Pd^{2\oplus}$, $Ag^{\oplus}$,
$Hg_2^{2\oplus}$, $Ir^{3\oplus}$, $Te^{4\oplus}$, $Se^{4\oplus}$, $Cu^{\oplus}$, $Cu^{2\oplus}$, $Rh^{3\oplus}$, $Re^{3\oplus}$, $As^{3\oplus}$,
$Sb^{3\oplus}$, $Bi^{3\oplus}$, $Sn^{4\oplus}$, $Mo^{6\oplus}$, $W^{6\oplus}$, $Fe^{3\oplus}$, $Sn^{2\oplus}$, $Pb^{2\oplus}$, $Ge^{4\oplus}$,
$Ni^{2\oplus}$, $Co^{2\oplus}$, $Tl^{\oplus}$, $Cd^{2\oplus}$, $Fe^{2\oplus}$, $Cr^{2\oplus}$, $Ga^{3\oplus}$, $Cr^{3\oplus}$, $Ta^{5\oplus}$,
$Zn^{2\oplus}$, $In^{3\oplus}$, $Y^{3\oplus}$, $Ru^{5\oplus}$, $Mn^{2\oplus}$, $Si^{4\oplus}$, $V^{2\oplus}$, $Zr^{4\oplus}$, $Hf^{4\oplus}$,
$Ce^{3\oplus}$, $Al^{3\oplus}$, $Be^{2\oplus}$, $Ti^{2\oplus}$, $U^{3\oplus}$, $Th^{4\oplus}$, ou $Np^{3\oplus}$, et
$L^1$, $L^2$, $L^3$, $L^4$ sont identiques ou différents, m, n, o et p sont les nombres 0 à 6, m, n, o et p pris ensemble sont les nombres 1 à 8,
$L^1$, $L^2$, $L^3$, $L^4$ ayant les significations suivantes :
$F^{\ominus}$, $Cl^{\ominus}$, $Br^{\ominus}$, $I^{\ominus}$, $CN^{\ominus}$, $CO$, $NO_3^{\ominus}$, $CH_3COO^{\ominus}$, $CH_3SO_3^{\ominus}$ ou $H_3PO_2^{\ominus}$ ou, en tant que ligand, RCN (avec R = alkyle en $C_1$-$C_6$, cycloalkyle, aryle),
$NR^1R^2R^3$ (avec $R^1$, $R^2$, $R^3$ identiques ou différents et $R^1 = R^2 = R^3 = H$, alkyle en $C_1$-$C_{10}$, cycloalkyle, aryle),
$R^1$-$R^2N$-$(CH_2)_n$-$NR^1R^2$ (avec $R^1$, $R^2$ identiques ou différents et $R^1 = R^2 = $ alkyle en $C_1$-$C_6$, cycloalkyle; n = 1 à 6),
$PR^1R^2R^3$ (avec $R^1$, $R^2$, $R^3$ identiques ou différents et $R^1 = R^2 = R^3 = H$, alkyle en $C_1$-$C_6$ cycloalkyle, aryle, alkoxy en $C_1$-$C_6$, cycloalcoxy, aryloxy),
$OPR^1R^2R^3$ (avec $R^1$, $R^2$, $R^3$ identiques ou différents et $R^1 = R^2 = R^3 = $ alkle en $C_1$-$C_6$, cycloalkyle, aryle, alkoxy en $C_1$-$C_6$, cycloalkoxy, aryloxy),
pyridine, diméthylsulfoxyde, acétylacétone, éther, triamide d'acide phosphorique hexaméthylique, N-méthylpyrrolidone, sulfolane, carbonate de propanediol-1,2, acétone, acétate d'éthyle, diméthylformamide ou N,N-diméthylacétamide,
ou à partir d'une suspension de $Fe(CO)_9$, dans un solvant aprotique, polaire ou non polaire, le métal,
sur un support polymère et électriquement conducteur de la formule générale (II):

$[M''_y (P)]_x$ (II)

dans laquelle M" = Li, Na, K, Rb, Cs;
P = -(CH)-, -$(C_6H_4)$-, -$(C_4H_2S)$-, -$(C_6H_4S)$-, -$(C_4H_2O)$-, -$(C_4H_2NH)$-, -$(C_6H_4O)$-, -$(C_5H_3N)$-
y = 0,001 à 0,6 et x = 5 à 1000,
ou sur un support polymère et électriquement conducteur de la formule générale (III):

$[(P)(X)_y]_x$ (III)

dans laquelle p correspond aux groupes indiqués au sujet de la formule (II),
X = $ClO_4^{\ominus}$, $AsF_6^{\ominus}$, $PF_6^{\ominus}$, $SbF_6^{\ominus}$, $BF_4^{\ominus}$, $HSO_4^{\ominus}$, $CF_3SO_3^{\ominus}$, $Br^{\ominus}$,
Y = 0,001 à 0,6 et x = 5 à 1000,

2. Procédé suivant la revendication 1, caractérisé en ce que l'on effectue chimiquement le dépôt du métal sur un support polymère et électriquement conducteur de la formule générale (II), lorsque y = 0,1 à 0,6 et x = 5 à 1000, éventuellement en présence d'un agent auxiliaire de reduction comme l'hydrazine, $SnCl_2$ ou $H_3PO_2$.

3. Procédé suivant la revendication 1, caractérisé en ce que l'on effectue électrochimiquement le dépôt du métal sur un support polymère et électriquement conducteur de la formule générale (II) ou (III), lorsque y = 0,001 à 0,1 et x = 5 à 1000, le support polymère et électriquement conducteur représentant la matière active comme cathode dans une cellule d'électrolyse.

4. Procédé suivant la revendication 1, caractérisé en ce que le solvant polaire aprotique est l'acétonitrile, le sulfolane, le carbonate de propanediol-1, 2, l'acétone, l'acétylacétone, l'acétate d'éthyle, l'éther diéthylique, le phosphate triméthyle, le phosphate de tributyle, le diméthylformamide, le N-N-diméthyl-acétamide, la N-méthylpyrrolidone, le diméthylsulfoxyde ou le triamide d'acide phosphorique hexaméthylique, et le solvant aprotique non polaire est le n-hexane, le n-heptane, le n-octane, l'éther de pétrole, la ligroïne, le benzène, le toluène ou le xylène.

5. Procédé suivant la revendication 1, caractérisé en ce que le dépôt du métal est effectué sur le support polymère et électriquement conducteur de la formule générale (II) à des températures de -100 à +100°C.

6. Utilisation des supports polymères et électriquement conducteurs, revêtus de métal, préparés suivant la revendication 1, en électrotechnique, pour la fabrication de cellules solaires, pour la transformation et le fixage d'un rayonnement et pour la fabrication de commutateurs électriques et magnétiques et de mémoires électriques.

7. Utilisation des supports polymères et électriquement conducteurs, revêtus de métal, préparés suivant la revendication 1, pour la protection antistatique des matières plastiques.

8. Utilisation des supports polymères et électriquement conducteurs, revêtus de métal, préparés suivant la revendication 1, en tant que catalyseurs hétérogènes.